# EUROPEAN PATENT APPLICATION

(11) **EP 2 458 314 A2**
(43) Date of publication of application: **30.05.2012**
(21) Application number: 11190385.2
(22) Date of filing: 23.11.2011
(51) Int. Cl.: F28D 15/00, F28D 15/02, H01L 23/46, H05K 7/20

(54) **Heat exchanger with inner fluid to actuate the external fluid pump**

(30) Priority: 24.11.2010 US 953521
(71) Applicant: Yang, Tai-Her, Si-Hu Town Dzan-Hwa (TW)
(72) Inventor: Yang, Tai-Her, Si-Hu Town Dzan-Hwa (TW)
(74) Representative: Wright, Howard Hugh Burnby

(57) **Abstract**

The present invention provides a heat exchanger with inner fluid to actuate the external fluid pump capable of driving one or more than one of fluid actuation devices through fluids passing through the heat exchanger having thermal-energy fluid pipe, without utilizing external mechanical rotational kinetic energy or power of electric motors; respectively driving external fluid pumping blade devices installed at lateral sides of the heat exchanger having thermal-energy fluid pipe with a direct or non-contact transmission means, so as to drive the external fluid to pass through the heat exchanger for increasing the heat exchange efficiency of the heat exchanger.

## Description

### BACKGROUND OF THE INVENTION

### (a) Field of the Invention

The present invention provides a heat exchanger with inner fluid to actuate the external fluid pump capable of driving one or more than one of fluid actuation devices through fluids passing through the heat exchanger having thermal-energy fluid pipe, without utilizing external mechanical rotational kinetic energy or power of electric motors; respectively driving external fluid pumping blade devices installed at lateral sides of the heat exchanger having thermal-energy fluid pipe with a direct or non-contact transmission means, so as to drive the external fluid to pass through the heat exchanger for increasing the heat exchange efficiency of the heat exchanger.

### (b) Description of the Prior Art

A conventional heat exchanger having thermal-energy fluid pipe often rotates external fluid pumping blade devices through external mechanical rotational kinetic energy or power of electric motor, so as to drive the external fluid to pass through the heat exchanger having thermal-energy fluid pipe for increasing the heat exchange efficiency of the heat exchanger. But disadvantages of the conventional art are raising the installation cost and consuming unnecessary energy.

### SUMMARY OF THE INVENTION

The heat exchanger with inner fluid to actuate the external fluid pump according to the present invention drives one or more than one of fluid actuation devices for generating rotational kinetic energy through thermal-energy fluid passing through a heat exchanger composed by fluid pipe; and external fluid pumping blade devices installed at lateral sides of the heat exchanger having thermal-energy fluid pipe are respectively driven with a direct or non-contact transmission means, so as to drive the external fluid to pass through the heat exchanger having thermal-energy fluid pipe for increasing the heat exchange efficiency of the heat exchanger having thermal-energy fluid pipe.

According to a second aspect of the present invention, a heat exchanger comprises a heat exchanger device (100) arranged to permit passage of a fluid from an input to an output through the heat exchanger device (100); at least one output/input pipeline (102, 103) of a fluid actuation device assembly (20) connected in parallel and disposed between the input and the output of the heat exchanger device (100), or are connected in series with the input and/or the output of the heat exchanger (100), then two ends of the fluid actuation device assembly (20) and the heat exchanger device (100) being connected in series are used for outputting/inputting fluid; and a fluid actuation device assembly (20) comprised of the output/input pipeline (102, 103), and the flow of fluid in the output/input pipeline (102, 103) of the fluid actuation device assembly (20) arranged to drive the fluid powering blade device (221), then the output shaft of the fluid powering blade device (221) arranged to drive the external fluid pumping blade device (202) directly, or the fluid powering blade device (221) arranged to drive the passive rotating part of magnetic coupling member (211), then an active rotating part of magnetic coupling member (212) arranged to drive the external fluid pumping blade device (202).

### BRIEF DESCRIPTION OF THE DRAWINGS

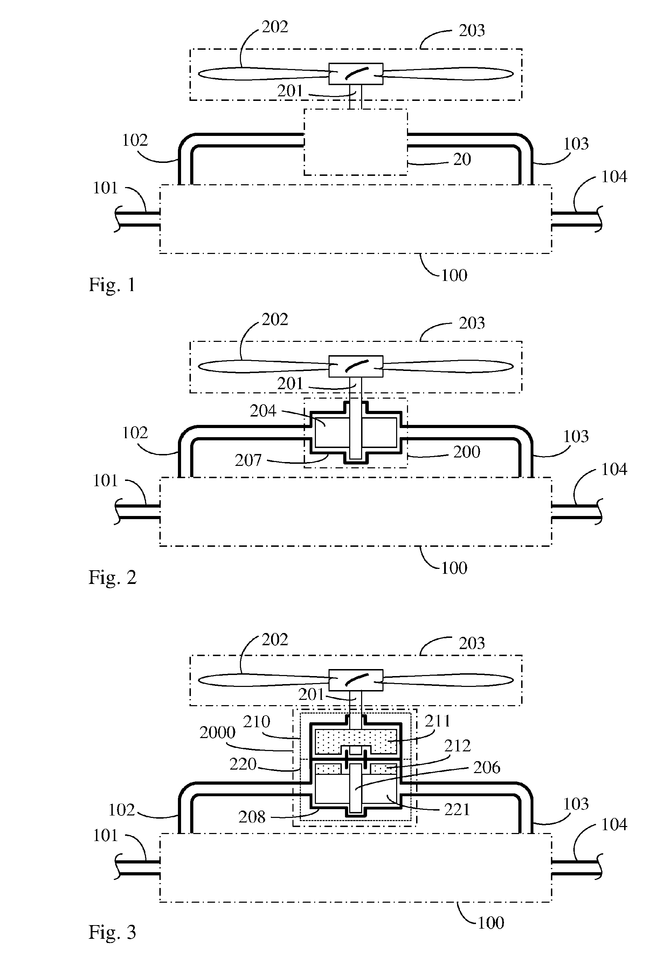

FIG 1 is a schematic view showing the foundational structure of the present invention.
FIG 2 is a schematic structural view showing the embodiment of present invention that a direct-driving type fluid actuation device (200) drives an external fluid pumping blade device(202) in the heat exchanger having thermal-energy fluid pipe.
FIG 3 is a schematic structural view showing the embodiment of the present invention that a non-contact transmission type fluid actuation device (2000) drives an external fluid pumping blade device (202) in the heat exchanger having thermal-energy fluid pipe.

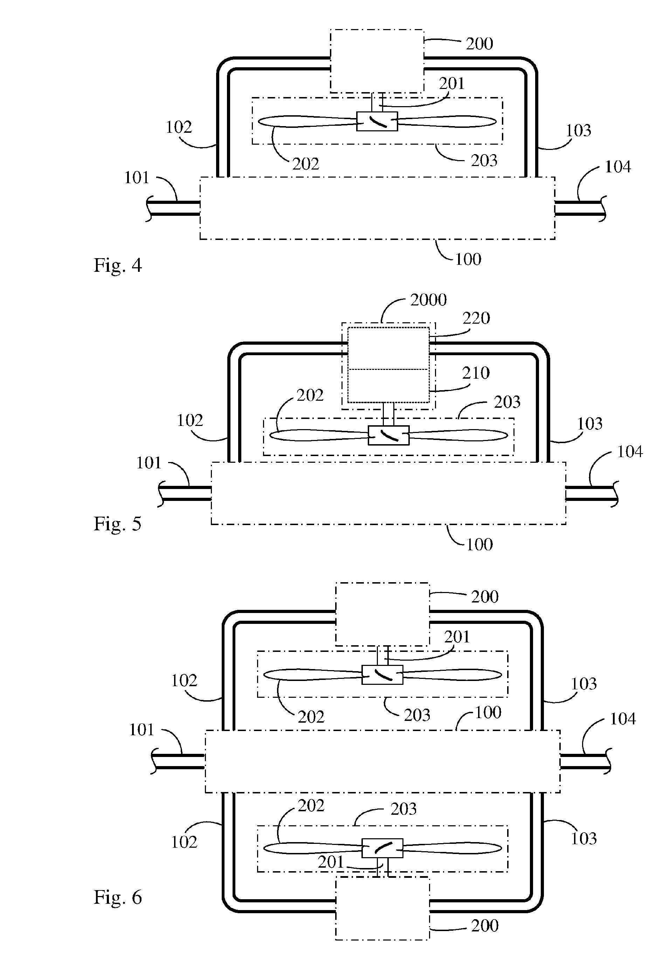

FIG 4 is a schematic structural view showing the embodiment of the present invention that the external fluid pumping blade device (202) is installed between the direct-driving type fluid actuation device (200) and the heat exchanger having thermal-energy fluid pipe (100).
FIG 5 is a schematic structural view showing the embodiment of the present invention that the external fluid pumping blade device (202) is installed between the non-contact transmission type fluid actuation device (2000) and the heat exchanger having thermal-energy fluid pipe (100).
FIG 6 is a schematic structural view showing that the direct-driving type fluid actuation devices (200) is installed at any two of the top, the bottom, the right, the left, the front and the rear sides of the heat exchanger having thermal-energy fluid pipe (100), and the two external fluid pumping blade devices (202) thereof being respectively installed between the heat exchanger having thermal-energy fluid pipe (100) and the direct-driving type fluid actuation devices (200) installed at two sides of the heat exchanger having thermal-energy fluid pipe (100).

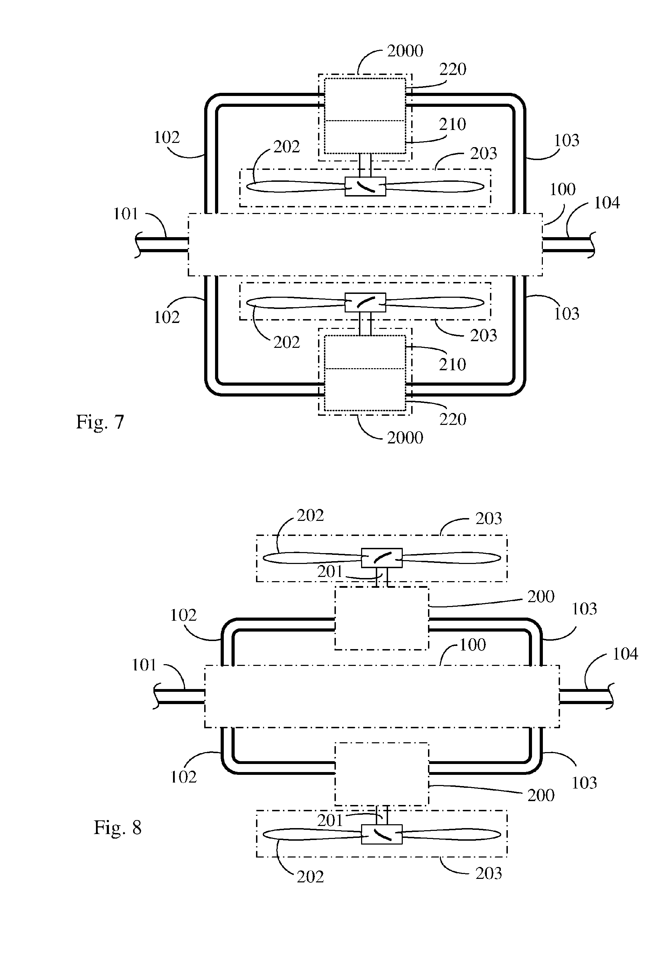

FIG 7 is a schematic structural view showing that the non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed between the heat exchanger having thermal-energy fluid pipe (100) and the non-contact transmission type fluid actuation devices (2000) installed at two sides of the heat exchanger having thermal-energy fluid pipe (100).
FIG 8 is a schematic structural view showing that the direct-driving type fluid actuation devices (200) is installed at any two of the top, the bottom, the right, the left, the front and the rear sides of the heat exchanger having thermal-energy fluid pipe (100), and the two external fluid pumping blade devices (202) thereof are respectively installed at the outer sides of the direct-driving type fluid actuation devices (200) installed at two sides of the heat exchanger having thermal-energy fluid pipe (100).

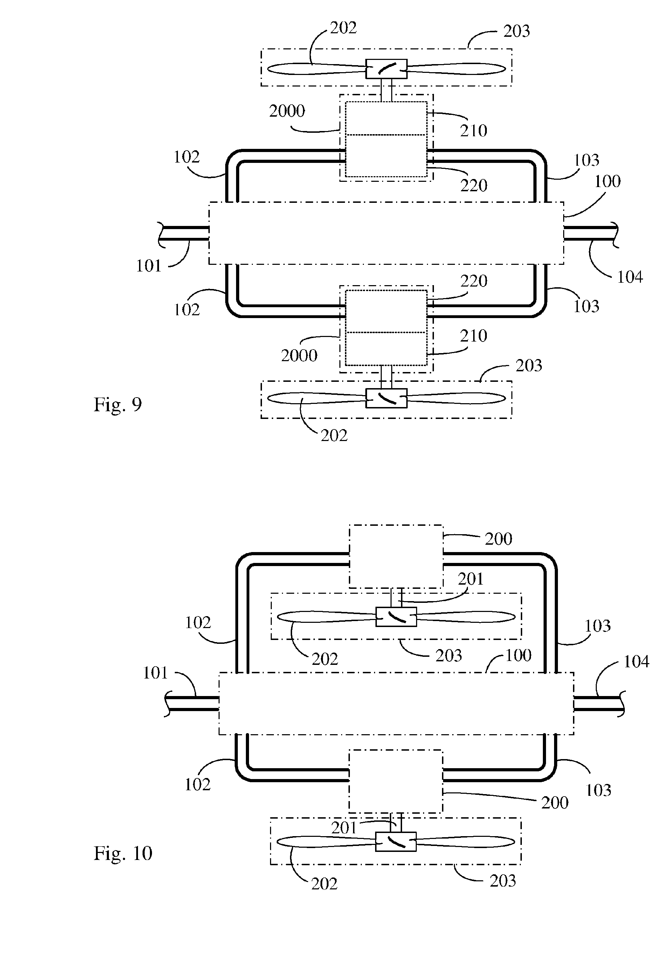

FIG 9 is a schematic structural view showing that the non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed at the outer sides of the non-contact transmission type fluid actuation devices (2000) installed at two sides of the heat exchanger having thermal-energy fluid pipe (100).
FIG 10 is a schematic structural view showing that the direct-driving type fluid actuation devices (200) are installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined direct-driving type fluid actuation device (200) and the other thereof is installed at the outer side of the other direct-driving type fluid actuation device (200) combined with the heat exchanger having thermal-energy fluid pipe (100).

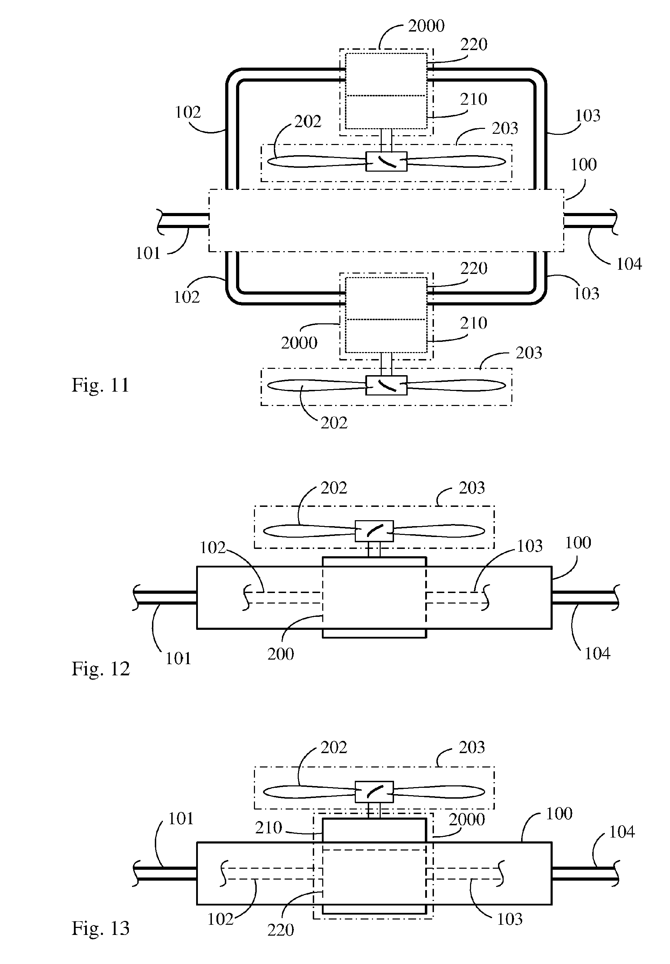

FIG 11 is a schematic structural view showing that the non-contact transmission type fluid actuation devices (2000) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined non-contact transmission type fluid actuation device (2000) and the other thereof is installed at the outer side of the other non-contact transmission type fluid actuation device (2000) combined with the heat exchanger having thermal-energy fluid pipe (100).
FIG 12 is a schematic structural view showing the embodiment of the present invention that the direct-driving type fluid actuation device (200) is installed inside the heat exchanger having thermal-energy fluid pipe (100), and the external fluid pumping blade device (202) is driven by a rotating shaft (201) installed at one side thereof.
FIG 13 is a schematic structural view showing the embodiment of the present invention that the non-contact transmission type fluid actuation device (2000) is installed inside the heat exchanger having thermal-energy fluid pipe (100), and the external fluid pumping blade device (202) being driven by a rotating shaft (201) installed at one side thereof.

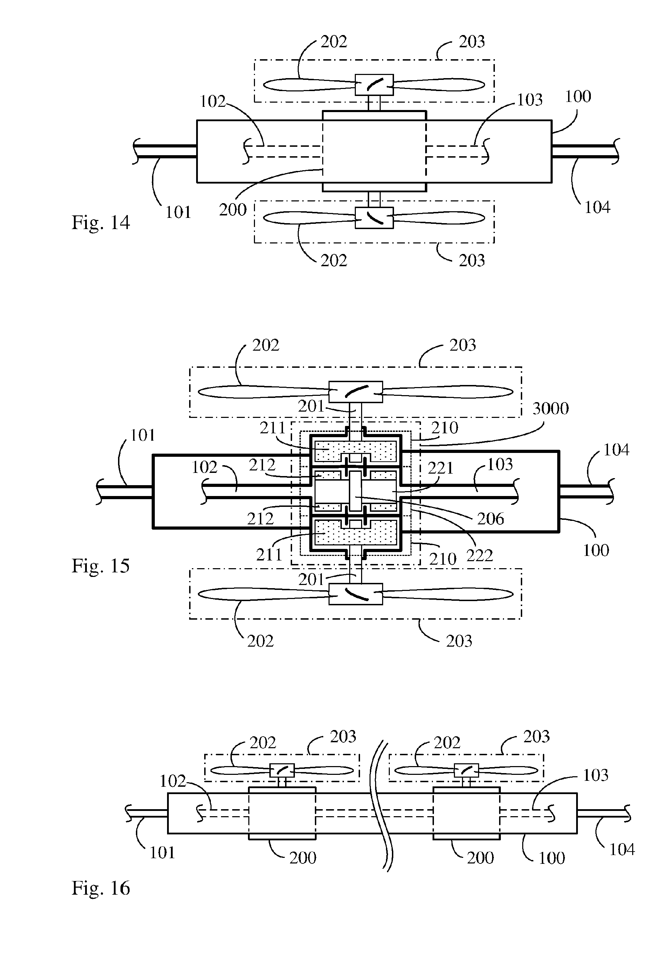

FIG 14 is a schematic structural view showing the embodiment of the present invention that the direct-driving type fluid actuation device (200) is installed inside the heat exchanger having thermal-energy fluid pipe (100), and the connected external fluid pumping blade devices (202) are respectively driven by two ends of the rotating shaft (201).
FIG 15 is a schematic structural view showing the embodiment of present invention that a dual-output non-contact transmission type fluid actuation device (3000) is installed inside the heat exchanger having thermal-energy fluid pipe (100), and the connected external fluid pumping blade devices (202) are respectively driven by individual rotating shafts (201) of the output sides of non-contact transmission type fluid actuation device (210) installed at two sides of the dual-output non-contact transmission type fluid actuation device (3000).
FIG 16 is a schematic structural view showing the embodiment of present invention that two or more than two of the direct-driving type fluid actuation devices (200) are installed inside the heat exchanger having thermal-energy fluid pipe (100), and rotating shafts (201) of the direct-driving type fluid actuation devices (200) installed at the same side respectively drive the external fluid pumping blade devices (202).

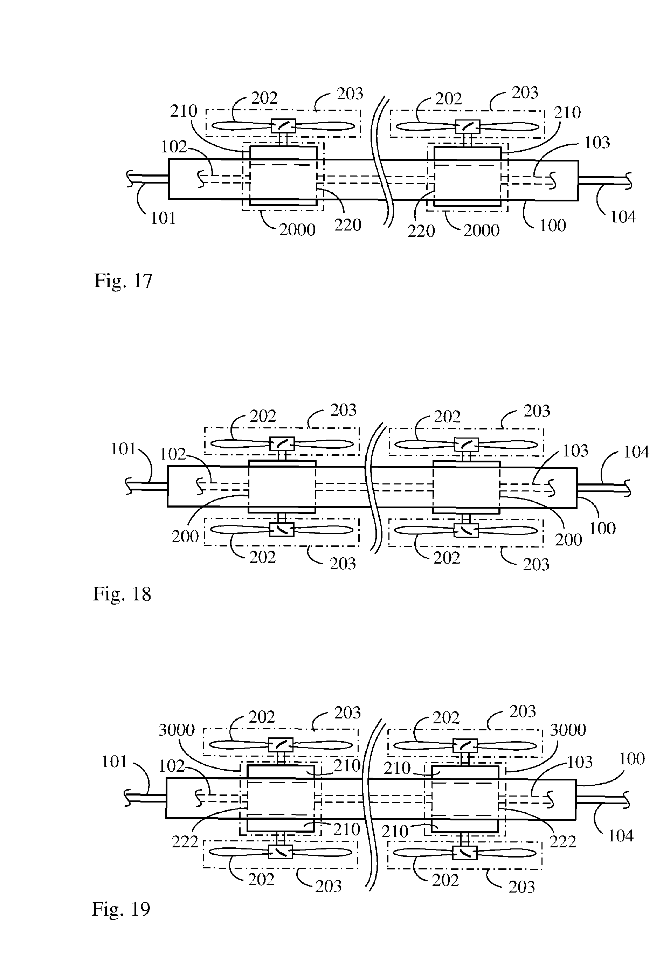

FIG 17 is a schematic structural view showing the embodiment of present invention that two or more than two of the non-contact transmission type fluid actuation devices (2000) are installed inside the heat exchanger having thermal-energy fluid pipe (100), and rotating shafts (201) of the non-contact transmission type fluid actuation devices (2000) installed at the same side respectively drive the external fluid pumping blade devices (202).
FIG 18 is a schematic structural view showing the embodiment of present invention that two or more than two of the direct-driving type fluid actuation devices (200) are installed inside the heat exchanger having thermal-energy fluid pipe (100), and two ends of each rotating shafts (201) of the direct-driving type fluid actuation devices (200) respectively drive the connected external fluid pumping blade devices (202).
FIG 19 is a schematic structural view showing the embodiment of present invention that two or more than two of the dual-output non-contact transmission type fluid actuation devices (3000) are installed inside the heat exchanger having thermal-energy fluid pipe (100), and individual rotating shafts (201) of the output sides of non-contact transmission type fluid actuation device (210) installed at two sides of the dual-output non-contact transmission type fluid actuation devices (3000) respectively drive the connected external fluid pumping blade devices (202).

### DESCRIPTION OF MAIN COMPONENT SYMBOLS

20 : Fluid actuation device assembly
100 : Heat exchanger having thermal-energy fluid pipe
101 - 104 : Fluid output/input pipeline
102 - 103 : Output/input pipeline of fluid actuation device
200 : Direct-driving type fluid actuation device
201 - 206 : Rotating shaft
202 : External fluid pumping blade device
203 : Blade protection device
204 : Fluid powering blade device
207 : Housing
208 : Housing
209 : Housing
210 : Output side of non-contact transmission type fluid actuation device
211 : Passive rotating part of magnetic coupling member
212 : Active rotating part of magnetic coupling member
220 : Active side of non-contact transmission type fluid actuation device
221 : Fluid powering blade device
222 : Active side of non-contact transmission type fluid actuation device with dual functional ends
2000 : Non-contact transmission type fluid actuation device
3000 : Dual-output non-contact transmission type fluid actuation device

### DETAILED DESCRIPTION OF THE PREFERRED EMBODIMENTS

A conventional heat exchanger having thermal-energy fluid pipe often rotates external fluid pumping blade devices through external mechanical rotational kinetic energy or power of electric motor, so as to drive the external fluid to pass through the heat exchanger having thermal-energy fluid pipe for increasing the heat exchange efficiency of the heat exchanger having thermal-energy fluid pipe. But disadvantages of the conventional art are raising the installation cost and consuming unnecessary energy;

The present invention provides a heat exchanger with inner fluid to actuate the external fluid pump capable of driving one or more than one of fluid actuation devices through fluids passing through heat exchanger having thermal-energy fluid pipe, without utilizing external mechanical rotational kinetic energy or power of electric motors; respectively driving external fluid pumping blade devices installed at lateral sides of the heat exchanger having thermal-energy fluid pipe with a direct or non-contact transmission means, so as to drive the external fluid to pass through the heat exchanger having thermal-energy fluid pipe for increasing the heat exchange efficiency of the heat exchanger having thermal-energy fluid pipe;
Embodiments of the heat exchanger with inner fluid to actuate the external fluid pump according to the present invention are as followings:
FIG 1 is a schematic view showing the foundational structure of the present invention;
As shown in FIG 1, it mainly consists of:
- Heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- Fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- Fluid actuation device assembly (20): it is through the fluid passing through to drive the internal fluid powering blades thereof to generate rotational kinetic energy, for driving an external fluid pumping blade device (202) with a direct or non-contact transmission means;
- Output/input pipelines of fluid actuation device (102), (103): provided for inputting or outputting the fluid passing through the heat exchanger having thermal-energy fluid pipe (100), and for inputting or outputting the fluid passing through the interior of a housing of the fluid actuation device assembly (20) for driving the fluid powering blade device, the output/input pipelines of fluid actuation device (102), (103) are in series or parallel shunt connected with the fluid output/input pipelines (101), (104), or with pipelines installed in the heat exchanger having thermal-energy fluid pipe (100), so when the cold/heat thermal-energy fluid passes through, the fluid powering blade device installed inside the fluid actuation device assembly (20) is driven for performing rotational operations so as to drive the external fluid pumping blade device (202) with a direct or non-contact transmission means;
- External fluid pumping blade device (202): constituted by a blade set capable of rotating for pumping fluid, combined on a rotating shaft, and is driven by the rotational kinetic energy from the fluid actuation device assembly (20) with a direct or non-contact transmission means, for pumping the external fluid to pass through the heat exchanger having thermal-energy fluid pipe (100) for exchanging heat with the heat exchanger having thermal-energy fluid pipe (100);

FIG 2 is a schematic structural view showing the embodiment of present invention that a direct-driving type fluid actuation device (200) drives an external fluid pumping blade device (202) in the heat exchanger having thermal-energy fluid pipe;
As shown in FIG 2, it mainly consists of:
- heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- Fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- Direct-driving type fluid actuation device (200): constituted by a rotating shaft (201), a bearing, a fluid powering blade device (204) combined with the rotating shaft (201) and a housing (207), wherein the housing (207) being inputted with the fluid having flowing kinetic energy through the output/input pipelines of fluid actuation device (102), (103), for moving the fluid powering blade device (204) inside the housing (207) so as to drive the rotating shaft (201) to generate rotational output, and further to drive the external fluid pumping blade device (202) installed at the side of the heat exchanger having thermal-energy fluid pipe (100) to perform rotational pumping operations;
- Output/input pipelines of fluid actuation device (102), (103): provided for inputting or outputting the fluid passing through the heat exchanger having thermal-energy fluid pipe (100), and passing through the interior of the housing (207) of the direct-driving type fluid actuation device (200) for driving the fluid powering blade device (204), the output/input pipelines of fluid actuation device (102), (103) are in series or parallel shunt connected with the fluid output/input pipelines (101), (104), or with pipelines installed in the heat exchanger having thermal-energy fluid pipe (100) serving as shunt connection, so when the cold/heat thermal-energy fluid passes through, the fluid powering blade device (204) installed inside the direct-driving type fluid actuation device assembly (200) is driven for performing rotational operations so as to drive the rotating shaft (201);
- External fluid pumping blade device (202): constituted by a blade set capable of rotating for pumping fluid, and combined on a rotating shaft (201) for being driven to rotate, thereby further pumping the external fluid to pass through the heat exchanger having thermal-energy fluid pipe (100) so as to exchange heat with the heat exchanger having thermal-energy fluid pipe (100).

FIG 3 is a schematic structural view showing the embodiment of the present invention that a non-contact transmission type fluid actuation device (2000) drives an external fluid pumping blade device (202) in the heat exchanger having thermal-energy fluid pipe;
As shown in FIG 3, it mainly consists of:
- Heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- Fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- Non-contact transmission type fluid actuation device (2000): constituted by a rotating shaft (206) installed with a fluid powering blade device (221), a bearing, an active rotating part of magnetic coupling member (212) and the fluid powering blade device (221) combined with the rotating shaft (206), and a housing (208), so as to structure an active side of non-contact transmission type fluid actuation device (220);
- The non-contact transmission type fluid actuation device (2000) is structured by one or more than one of following means which include:
   1. Between the active rotating part of magnetic coupling member (212) and the passive rotating part of magnetic coupling member (211), the transmission coupling is performed through the permanent magnetic pole attracting the other permanent magnetic pole;
   2. Between the active rotating part of magnetic coupling member (212) and the passive rotating part of magnetic coupling member (211), the transmission coupling is performed through the permanent magnetic pole attracting the coupled magnetic conductive member;
   3. Between the active rotating part of magnetic coupling member (212) and the passive rotating part of magnetic coupling member (211), the transmission coupling is performed through the permanent magnetic pole generating the turbine effect to the electric conductive member;
   4. Between the active rotating part of magnetic coupling member (212) and the passive rotating part of magnetic coupling member (211), the transmission coupling is performed through the permanent magnetic pole generating the electromagnetic effect to the squirrel-cage electromagnetic member;
   5. Between the active rotating part of magnetic coupling member (212) and the passive rotating part of magnetic coupling member (211), the transmission coupling is performed through the permanent magnetic pole generating the magnetic coupling effect to the reluctance structural member.

Being separated through the housing (208), the fluid powering blade device (221) installed inside the active side of non-contact transmission type fluid actuation device (220) and the passive rotating part of magnetic coupling member (211) installed inside the output side of non-contact transmission type fluid actuation device (210) can perform synchronous or non-synchronous rotational transmission coupling through the active rotating part of magnetic coupling member (212) combined with the fluid powering blade device (221), for driving the passive rotating part of magnetic coupling member (211) and the rotating shaft (201), thereby further driving the external fluid pumping blade device (202) installed at the side of the heat exchanger having thermal-energy fluid pipe (100);
- Output/input pipelines of fluid actuation device (102), (103): provided for inputting or outputting the fluid passing through the heat exchanger having thermal-energy fluid pipe (100), and the fluid passing through the interior of the housing (208) of the active side of non-contact transmission type fluid actuation device (220) of the non-contact transmission type fluid actuation device (2000) for driving the fluid powering blade device (221); the output/input pipelines of fluid actuation device (102), (103) is in series or parallel shunt connected with the fluid output/input pipelines (101), (104), so when the cold/heat thermal-energy fluid passes through, the fluid powering blade device (221) installed inside the active side of non-contact transmission type fluid actuation device (220) is driven for performing rotational pumping operations so as to drive the passive rotating part of magnetic coupling member (211) inside the output side of non-contact transmission type fluid actuation device (210) with a non-contact means, thereby further driving the rotating shaft (201);
- External fluid pumping blade device (202): constituted by a blade set capable of rotating for pumping fluid, and combined on a rotating shaft (201) for being driven to rotate, thereby further pumping the external fluid to pass through the heat exchanger having thermal-energy fluid pipe (100) so as to exchange heat with the heat exchanger having thermal-energy fluid pipe (100);
- Housing (208): serving as the housing for the non-contact transmission type fluid actuation device (2000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (208);

According to the present invention of heat exchanger with inner fluid to actuate the external fluid pump, the relative locations of the direct-driving type fluid actuation device (200) or the non-contact transmission type fluid actuation device (2000) and the heat exchanger having thermal-energy fluid pipe (100) are structured as followings:
FIG 4 is a schematic structural view showing the embodiment of the present invention that the external fluid pumping blade device (202) is installed between the direct-driving type fluid actuation device (200) and the heat exchanger having thermal-energy fluid pipe (100);
As shown in FIG 4, it mainly consists of:
- The direct-driving type fluid actuation device (200) is installed at one side of the heat exchanger having thermal-energy fluid pipe (100), including one or more than one of the top, the bottom, the left, the right, the front and the rear sides of the heat exchanger having thermal-energy fluid pipe (100), and the external fluid pumping blade device (202) is installed between the direct-driving type fluid actuation device (200) and the heat exchanger having thermal-energy fluid pipe (100);

FIG 5 is a schematic structural view showing the embodiment of the present invention that the external fluid pumping blade device (202) is installed between the non-contact transmission type fluid actuation device (2000) and the heat exchanger having thermal-energy fluid pipe (100);
As shown in FIG 5, it mainly consists of:
- The non-contact transmission type fluid actuation device (2000) is installed at one side of the heat exchanger having thermal-energy fluid pipe (100), including one or more than one of the top, the bottom, the left, the right, the front and the rear sides of the heat exchanger having thermal-energy fluid pipe (100), and the external fluid pumping blade device (202) is installed between the non-contact transmission type fluid actuation device (2000) and the heat exchanger having thermal-energy fluid pipe (100);

FIG 6 is a schematic structural view showing that the direct-driving type fluid actuation devices (200) is installed at any two of the top, the bottom, the right, the left, the front and the rear sides of the heat exchanger having thermal-energy fluid pipe (100), and the two external fluid pumping blade devices (202) thereof being respectively installed between the heat exchanger having thermal-energy fluid pipe (100) and the direct-driving type fluid actuation devices (200) installed at two sides of the heat exchanger having thermal-energy fluid pipe (100);
As shown in FIG 6, it mainly consists of:
- The direct-driving type fluid actuation device (200) is installed at any two of the top, the bottom, the right, the left, the front and the rear sides of the heat exchanger having thermal-energy fluid pipe (100), and the two external fluid pumping blade devices (202) thereof are respectively installed between the heat exchanger having thermal-energy fluid pipe (100) and the direct-driving type fluid actuation devices (200) installed at two sides of the heat exchanger having thermal-energy fluid pipe (100) and are respectively driven by the connected rotating shaft (201) of the direct-driving type fluid actuation device (200), and flowing directions of the fluids driven by the two external fluid pumping blade devices (202) can be the same or different.

FIG 7 is a schematic structural view showing that the non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed between the heat exchanger having thermal-energy fluid pipe (100) and the non-contact transmission type fluid actuation devices (2000) installed at two sides of the heat exchanger having thermal-energy fluid pipe (100);
As shown in FIG 7, it mainly consists of:
- The non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed between the heat exchanger having thermal-energy fluid pipe (100) and the non-contact transmission type fluid actuation devices (2000) installed at two sides of the heat exchanger having thermal-energy fluid pipe (100) and are respectively driven by the connected rotating shaft (201) of the non-contact transmission type fluid actuation devices (2000), and flowing directions of the fluids driven by the two external fluid pumping blade devices (202) can be the same or different.

FIG 8 is a schematic structural view showing that the direct-driving type fluid actuation devices (200) is installed at any two of the top, the bottom, the right, the left, the front and the rear sides of the heat exchanger having thermal-energy fluid pipe (100), and the two external fluid pumping blade devices (202) thereof are respectively installed at the outer sides of the direct-driving type fluid actuation devices (200) installed at two sides of the heat exchanger having thermal-energy fluid pipe (100);
As shown in FIG 8, it mainly consists of:
- The direct-driving type fluid actuation device (200) is installed at any two of the top, the bottom, the right, the left, the front and the rear sides of the heat exchanger having thermal-energy fluid pipe (100), and two external fluid pumping blade devices (202) thereof are respectively installed at the outer sides of the direct-driving type fluid actuation devices (200) installed at two sides of the heat exchanger having thermal-energy fluid pipe (100) and respectively driven by the connected rotating shaft (201) of the direct-driving type fluid actuation device (200), and flowing directions of the fluids driven by the two external fluid pumping blade devices (202) can be the same or different.

FIG 9 is a schematic structural view showing that the non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed at the outer sides of the non-contact transmission type fluid actuation devices (2000) installed at two sides of the heat exchanger having thermal-energy fluid pipe (100);
As shown in FIG 9, it mainly consists of:
- The non-contact transmission type fluid actuation devices (2000) are installed at any two of the top, the bottom, the right, the left, the front and the rear sides of the heat exchanger having thermal-energy fluid pipe (100), and two external fluid pumping blade devices (202) thereof are respectively installed at the outer sides of the non-contact transmission type fluid actuation devices (2000) installed at two sides of the heat exchanger having thermal-energy fluid pipe (100), and are respectively driven by the connected rotating shaft (201) of the non-contact transmission type fluid actuation devices (2000), and flowing directions of the fluids driven by the two external fluid pumping blade devices (202) can be the same or different.

FIG 10 is a schematic structural view showing that the direct-driving type fluid actuation devices (200) are installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined direct-driving type fluid actuation device (200) and the other thereof is installed at the outer side of the other direct-driving type fluid actuation device (200) combined with the heat exchanger having thermal-energy fluid pipe (100);
As shown in FIG 10, it mainly consists of:
- The direct-driving type fluid actuation devices (200) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined direct-driving type fluid actuation device (200) and the other thereof is installed at the outer side of the other direct-driving type fluid actuation device (200) combined with the heat exchanger having thermal-energy fluid pipe (100), and are respectively driven by the connected rotating shaft (201) of the direct-driving type fluid actuation device (200), and flowing directions of the fluids driven by the two external fluid pumping blade devices (202) can be the same or different.

FIG 11 is a schematic structural view showing that the non-contact transmission type fluid actuation devices (2000) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined non-contact transmission type fluid actuation device (2000) and the other thereof is installed at the outer side of the other non-contact transmission type fluid actuation device (2000) combined with the heat exchanger having thermal-energy fluid pipe (100);
As shown in FIG 11, it mainly consists of:
- The non-contact transmission type fluid actuation devices (2000) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined non-contact transmission type fluid actuation device (2000) and the other thereof is installed at the outer side of the other non-contact transmission type fluid actuation device (2000) combined with the heat exchanger having thermal-energy fluid pipe (100), and are respectively driven by the connected rotating shaft (201) of the non-contact transmission type fluid actuation devices (2000), and flowing directions of the fluids driven by the two external fluid pumping blade devices (202) can be the same or different.

According to the heat exchanger with inner fluid to actuate the external fluid pump of the present invention, the direct-driving type fluid actuation device (200) or the non-contact transmission type fluid actuation device (2000) can be further installed inside the heat exchanger having thermal-energy fluid pipe (100), and using the rotating shaft (201) to drive the external fluid pumping blade devices (202) for reducing the thickness of the whole structure;
According to the heat exchanger with inner fluid to actuate the external fluid pump of the present invention, when in practical application, the present invention can be structured as followings which include:
FIG 12 is a schematic structural view showing the embodiment of the present invention that the direct-driving type fluid actuation device (200) is installed inside the heat exchanger having thermal-energy fluid pipe (100), and the external fluid pumping blade device (202) is driven by a rotating shaft (201) installed at one side thereof;
As shown in FIG 12, it mainly consists of:
- The direct-driving type fluid actuation device (200) is installed inside the heat exchanger having thermal-energy fluid pipe (100), and the external fluid pumping blade device (202) is driven by the rotating shaft (201) installed at one side of the direct-driving type fluid actuation device (200).

FIG 13 is a schematic structural view showing the embodiment of the present invention that the non-contact transmission type fluid actuation device (2000) is installed inside the heat exchanger having thermal-energy fluid pipe (100), and the external fluid pumping blade device (202) being driven by a rotating shaft (201) installed at one side thereof;
As shown in FIG 13, it mainly consists of:
- The non-contact transmission type fluid actuation device (2000) is installed inside the heat exchanger having thermal-energy fluid pipe (100), and the external fluid pumping blade device (202) is driven by the rotating shaft (201) installed at the output side of non-contact transmission type fluid actuation device (210) of the non-contact transmission type fluid actuation device (2000).

FIG 14 is a schematic structural view showing the embodiment of the present invention that the direct-driving type fluid actuation device (200) is installed inside the heat exchanger having thermal-energy fluid pipe (100), and the connected external fluid pumping blade devices (202) are respectively driven by two ends of the rotating shaft (201);
As shown in FIG 14, it mainly consists of:
- The direct-driving type fluid actuation device (200) is installed inside the heat exchanger having thermal-energy fluid pipe (100), and the two ends of the rotating shaft (201) of the direct-driving type fluid actuation device (200) is served for respectively connecting the external fluid pumping blade devices (202), thereby pumping the external fluids in the same or different direction.

FIG 15 is a schematic structural view showing the embodiment of present invention that a dual-output non-contact transmission type fluid actuation device (3000) is installed inside the heat exchanger having thermal-energy fluid pipe (100), and the connected external fluid pumping blade devices (202) are respectively driven by individual rotating shafts (201) of the output sides of non-contact transmission type fluid actuation device (210) installed at two sides of the dual-output non-contact transmission type fluid actuation device (3000);
As shown in FIG 15, it mainly consists of:
- the dual-output non-contact transmission type fluid actuation device (3000) is installed inside the heat exchanger having thermal-energy fluid pipe (100), and the individual rotating shafts (201) of the output sides of non-contact transmission type fluid actuation device (210) installed at two sides of the dual-output non-contact transmission type fluid actuation device (3000) respectively drive the external fluid pumping blade devices (202), thereby pumping the external fluids in the same or different direction.
- The dual-output non-contact transmission type fluid actuation device (3000) is provided with an active side of non-contact transmission type fluid actuation device with dual functional ends (222) constituted by a fluid powering blade device (221), and active rotating parts of magnetic coupling member (212) combined and driven at the two sides, and a rotating shaft (206) and a housing (209), and is provided with two passive rotating parts of magnetic coupling member (211) inside the output side of the two non-contact transmission type fluid actuation devices (210) to perform non-contact coupling transmission with the two active rotating parts of magnetic coupling member (212) installed at two sides of the active side of non-contact transmission type fluid actuation device with dual functional ends (222); rotating shafts (201) driven by the two passive rotating parts of magnetic coupling member (211) respectively drive the external fluid pumping blade devices (202), thereby pumping the external fluids in the same or different direction;
- The dual-output non-contact transmission type fluid actuation device (3000) is structured by one or more than one of following means which include:
   1. Between the active rotating part of magnetic coupling member (212) and the passive rotating part of magnetic coupling member (211), the transmission coupling is performed through the permanent magnetic pole attracting the other permanent magnetic pole;
   2. Between the active rotating part of magnetic coupling member (212) and the passive rotating part of magnetic coupling member (211), the transmission coupling is performed through the permanent magnetic pole attracting the coupled magnetic conductive member;
   3. Between the active rotating part of magnetic coupling member (212) and the passive rotating part of magnetic coupling member (211), the transmission coupling is performed through the permanent magnetic pole generating the turbine effect to the electric conductive member;
   4. Between the active rotating part of magnetic coupling member (212) and the passive rotating part of magnetic coupling member (211), the transmission coupling is performed through the permanent magnetic pole generating the electromagnetic effect to the squirrel-cage electromagnetic member;
   5. Between the active rotating part of magnetic coupling member (212) and the passive rotating part of magnetic coupling member (211), the transmission coupling is performed through the permanent magnetic pole generating the magnetic coupling effect to the reluctance structural member.
- External fluid pumping blade devices (202): installed at two sides of the heat exchanger having thermal-energy fluid pipe (100), and are respectively driven by the rotating shafts (201) of the output sides of non-contact transmission type fluid actuation device (210), thereby pumping the external fluids in the same or different direction;
- Housing (209): serving as the housing for the dual-output non-contact transmission type fluid actuation device (3000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (209);
   According to the present invention, the heat exchanger with inner fluid to actuate the external fluid pump, two or more than two of at least one or more than one of following fluid actuation devices can be further installed to the heat exchanger having thermal-energy fluid pipe (100) with, which include:
   (1) Direct-driving type fluid actuation device (200);
   (2) Non-contact transmission type fluid actuation device (2000);
   (3) Dual-output non-contact transmission type fluid actuation device (3000);

Disclosures are as followings:
FIG 16 is a schematic structural view showing the embodiment of present invention that two or more than two of the direct-driving type fluid actuation devices (200) are installed inside the heat exchanger having thermal-energy fluid pipe (100), and rotating shafts (201) of the direct-driving type fluid actuation devices (200) installed at the same side respectively drive the external fluid pumping blade devices (202);
As shown in FIG 16, it mainly consists of:
- Two or more than two of the direct-driving type fluid actuation devices (200) are installed inside the heat exchanger having thermal-energy fluid pipe (100), and rotating shafts (201) of the direct-driving type fluid actuation devices (200) installed at the same side respectively drive the external fluid pumping blade devices (202).

FIG 17 is a schematic structural view showing the embodiment of present invention that two or more than two of the non-contact transmission type fluid actuation devices (2000) are installed inside the heat exchanger having thermal-energy fluid pipe (100), and rotating shafts (201) of the non-contact transmission type fluid actuation devices (2000) installed at the same side respectively drive the external fluid pumping blade devices (202);
As shown in FIG 17, it mainly consists of:
- two or more than two of the non-contact transmission type fluid actuation devices (2000) are installed inside the heat exchanger having thermal-energy fluid pipe (100); and rotating shafts (201) of the output sides of non-contact transmission type fluid actuation devices (210) installed at the same side of the non-contact transmission type fluid actuation devices (2000) respectively drive the external fluid pumping blade devices (202).

FIG 18 is a schematic structural view showing the embodiment of present invention that two or more than two of the direct-driving type fluid actuation devices (200) are installed inside the heat exchanger having thermal-energy fluid pipe (100), and two ends of each rotating shafts (201) of the direct-driving type fluid actuation devices (200) respectively drive the connected external fluid pumping blade devices (202);
As shown in FIG 18, it mainly consists of:
- Two or more than two of the direct-driving type fluid actuation devices (200) are installed inside the heat exchanger having thermal-energy fluid pipe (100), and two ends of each rotating shafts (201) of the direct-driving type fluid actuation devices (200) respectively connect with the external fluid pumping blade devices (202), thereby pumping the external fluids in the same or different direction.

FIG 19 is a schematic structural view showing the embodiment of present invention that two or more than two of the dual-output non-contact transmission type fluid actuation devices (3000) are installed inside the heat exchanger having thermal-energy fluid pipe (100), and individual rotating shafts (201) of the output sides of non-contact transmission type fluid actuation device (210) installed at two sides of the dual-output non-contact transmission type fluid actuation devices (3000) respectively drive the connected external fluid pumping blade devices (202);
As shown in FIG 19, it mainly consists of:
- Two or more than two of the dual-output non-contact transmission type fluid actuation devices (3000) are installed inside the heat exchanger having thermal-energy fluid pipe (100), and individual rotating shafts (201) of the output sides of non-contact transmission type fluid actuation device (210) installed at two sides of the dual-output non-contact transmission type fluid actuation devices (3000) respectively drive the external fluid pumping blade devices (202), thereby pumping the external fluids in the same or different direction.
- The dual-output non-contact transmission type fluid actuation device (3000) is installed with a fluid powering blade device (221), active rotating parts of magnetic coupling member (212) combined at two sides for driving, a rotating shaft (206) and a housing (209) to together constituted an active side of non-contact transmission type fluid actuation device with dual functional ends (222), and two sides of the active side of non-contact transmission type fluid actuation device with dual functional ends (222) are respectively installed with the output sides of non-contact transmission type fluid actuation device (210), and passive rotating parts of magnetic coupling member (211) are installed inside the output sides of non-contact transmission type fluid actuation device (210) for serving to perform non-contact coupling transmission with the two active rotating parts of magnetic coupling member (212) installed at two sides of the active side of non-contact transmission type fluid actuation device with dual functional ends (222), and rotating shafts (201) driven by the two passive rotating parts of magnetic coupling member (211) respectively drive the external fluid pumping blade devices (202), thereby pumping the external fluids in the same or different direction;
- The dual-output non-contact transmission type fluid actuation device (3000) is structured by one or more than one of following means which include:
   1. Between the active rotating part of magnetic coupling member (212) and the passive rotating part of magnetic coupling member (211), the transmission coupling is performed through the permanent magnetic pole attracting the other permanent magnetic pole;
   2. Between the active rotating part of magnetic coupling member (212) and the passive rotating part of magnetic coupling member (211), the transmission coupling is performed through the permanent magnetic pole attracting the coupled magnetic conductive member;
   3. Between the active rotating part of magnetic coupling member (212) and the passive rotating part of magnetic coupling member (211), the transmission coupling is performed through the permanent magnetic pole generating the turbine effect to the electric conductive member;
   4. Between the active rotating part of magnetic coupling member (212) and the passive rotating part of magnetic coupling member (211), the transmission coupling is performed through the permanent magnetic pole generating the electromagnetic effect to the squirrel-cage electromagnetic member;
   5. Between the active rotating part of magnetic coupling member (212) and the passive rotating part of magnetic coupling member (211), the transmission coupling is performed through the permanent magnetic pole generating the magnetic coupling effect to the reluctance structural member;
- External fluid pumping blade devices (202): installed at two sides of the heat exchanger having thermal-energy fluid pipe (100), and are respectively driven by the rotating shafts (201) of the output sides of non-contact transmission type fluid actuation device (210), thereby pumping the external fluids in the same or different direction;
- Housing (209): serving as the housing for the dual-output non-contact transmission type fluid actuation device (3000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (209).

According to the heat exchanger with inner fluid to actuate the external fluid pump of the present invention, when in practical application, the present invention can further be structured as followings which include:
- In the heat exchanger with inner fluid to actuate the external fluid pump, the outer periphery of the external fluid pumping blade device (202) can be further installed with a blade protection device (203), such as a mesh-shaped device or mask-shaped device for providing safety protection.

## Claims

1. A heat exchanger with inner fluid to actuate the external fluid pump, which is capable of driving one or more than one of fluid actuation devices through fluids passing through heat exchanger having thermal-energy fluid pipe, without utilizing external mechanical rotational kinetic energy or power of electric motors; respectively driving external fluid pumping blade devices installed at lateral sides of the heat exchanger having thermal-energy fluid pipe with a direct or non-contact transmission means, so as to drive the external fluid to pass through the heat exchanger having thermal-energy fluid pipe for increasing the heat exchange efficiency of the heat exchanger having thermal-energy fluid pipe, wherein it mainly consists of:
- - heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- - fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- - fluid actuation device assembly (20): it is through the fluid passing through to drive the internal fluid powering blades thereof to generate rotational kinetic energy, for driving an external fluid pumping blade device (202) with a direct or non-contact transmission means;
- - output/input pipelines of fluid actuation device (102), (103): provided for inputting or outputting the fluid passing through the heat exchanger having thermal-energy fluid pipe (100), and for inputting or outputting the fluid passing through the interior of a housing of the fluid actuation device assembly (20) for driving the fluid powering blade device, the output/input pipelines of fluid actuation device (102), (103) are in series or parallel shunt connected with the fluid output/input pipelines (101), (104), or with pipelines installed in the heat exchanger having thermal-energy fluid pipe (100), so when the cold/heat thermal-energy fluid passes through, the fluid powering blade device installed inside the fluid actuation device assembly (20) is driven for performing rotational operations so as to drive the external fluid pumping blade device (202) with a direct or non-contact transmission means;
- - external fluid pumping blade device (202): constituted by a blade set capable of rotating for pumping fluid, combined on a rotating shaft, and is driven by the rotational kinetic energy from the fluid actuation device assembly (20) with a direct or non-contact transmission means, for pumping the external fluid to pass through the heat exchanger having thermal-energy fluid pipe (100) for exchanging heat with the heat exchanger having thermal-energy fluid pipe (100).

2. The heat exchanger with inner fluid to actuate the external fluid pump as claimed in claim 1 includes using a direct-driving type fluid actuation device (200) to drive an external fluid pumping blade device (202), wherein it mainly consists of:
- - heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- - fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- - direct-driving type fluid actuation device (200): constituted by a rotating shaft (201), a bearing, a fluid powering blade device (204) combined with the rotating shaft (201) and a housing (207), wherein the housing (207) being inputted with the fluid having flowing kinetic energy through the output/input pipelines of fluid actuation device (102), (103), for moving the fluid powering blade device (204) inside the housing (207) so as to drive the rotating shaft (201) to generate rotational output, and further to drive the external fluid pumping blade device (202) installed at the side of the heat exchanger having thermal-energy fluid pipe (100) to perform rotational pumping operations;
- - Output/input pipelines of fluid actuation device (102), (103): provided for inputting or outputting the fluid passing through the heat exchanger having thermal-energy fluid pipe (100), and passing through the interior of the housing (207) of the direct-driving type fluid actuation device (200) for driving the fluid powering blade device (204), the output/input pipelines of fluid actuation device (102), (103) are in series or parallel shunt connected with the fluid output/input pipelines (101), (104), or with pipelines installed in the heat exchanger having thermal-energy fluid pipe (100) serving as shunt connection, so when the cold/heat thermal-energy fluid passes through, the fluid powering blade device (204) installed inside the direct-driving type fluid actuation device assembly (200) is driven for performing rotational operations so as to drive the rotating shaft (201);
- - external fluid pumping blade device (202): constituted by a blade set capable of rotating for pumping fluid, and combined on a rotating shaft (201) for being driven to rotate, thereby further pumping the external fluid to pass through the heat exchanger having thermal-energy fluid pipe (100) so as to exchange heat with the heat exchanger having thermal-energy fluid pipe (100).

3. The heat exchanger with inner fluid to actuate the external fluid pump as claimed in claim 1 includes using a non-contact transmission type fluid actuation device (2000) to drive an external fluid pumping blade device (202), wherein it mainly consists of:
- - heat exchanger having thermal-energy fluid pipe (100): constituted by a heat exchanger device allowing cold/heat thermal-energy fluid pipe to pass through, so cold/heat energy is discharged to the surrounding when the cold/heat thermal-energy fluid passing through the pipe;
- - fluid output/input pipelines (101), (104): constituted by components with good heat conductivity, and serving as the fluid output/input pipelines for outputting/inputting cold/heat thermal-energy fluid to the heat exchanger having thermal-energy fluid pipe (100);
- - non-contact transmission type fluid actuation device (2000): constituted by a rotating shaft (206) installed with a fluid powering blade device (221), a bearing, an active rotating part of magnetic coupling member (212) and the fluid powering blade device (221) combined with the rotating shaft (206), and a housing (208), so as to structure an active side of non-contact transmission type fluid actuation device (220);
- - the non-contact transmission type fluid actuation device (2000) is structured by one or more than one of following means which include:
1) between the active rotating part of magnetic coupling member (212) and the passive rotating part of magnetic coupling member (211), the transmission coupling is performed through the permanent magnetic pole attracting the other permanent magnetic pole;
2) between the active rotating part of magnetic coupling member (212) and the passive rotating part of magnetic coupling member (211), the transmission coupling is performed through the permanent magnetic pole attracting the coupled magnetic conductive member;
3) between the active rotating part of magnetic coupling member (212) and the passive rotating part of magnetic coupling member (211), the transmission coupling is performed through the permanent magnetic pole generating the turbine effect to the electric conductive member;
4) between the active rotating part of magnetic coupling member (212) and the passive rotating part of magnetic coupling member (211), the transmission coupling is performed through the permanent magnetic pole generating the electromagnetic effect to the squirrel-cage electromagnetic member;
5) between the active rotating part of magnetic coupling member (212) and the passive rotating part of magnetic coupling member (211), the transmission coupling is performed through the permanent magnetic pole generating the magnetic coupling effect to the reluctance structural member;
being separated through the housing (208), the fluid powering blade device (221) installed inside the active side of non-contact transmission type fluid actuation device (220) and the passive rotating part of magnetic coupling member (211) installed inside the output side of non-contact transmission type fluid actuation device (210) can perform synchronous or non-synchronous rotational transmission coupling through the active rotating part of magnetic coupling member (212) combined with the fluid powering blade device (221), for driving the passive rotating part of magnetic coupling member (211) and the rotating shaft (201), thereby further driving the external fluid pumping blade device (202) installed at the side of the heat exchanger having thermal-energy fluid pipe (100);
- - output/input pipelines of fluid actuation device (102), (103): provided for inputting or outputting the fluid passing through the heat exchanger having thermal-energy fluid pipe (100), and the fluid passing through the interior of the housing (208) of the active side of non-contact transmission type fluid actuation device (220) of the non-contact transmission type fluid actuation device (2000) for driving the fluid powering blade device (221); the output/input pipelines of fluid actuation device (102), (103) is in series or parallel shunt connected with the fluid output/input pipelines (101), (104), so when the cold/heat thermal-energy fluid passes through, the fluid powering blade device (221) installed inside the active side of non-contact transmission type fluid actuation device (220) is driven for performing rotational pumping operations so as to drive the passive rotating part of magnetic coupling member (211) inside the output side of non-contact transmission type fluid actuation device (210) with a non-contact means, thereby further driving the rotating shaft (201);
- - external fluid pumping blade device (202): constituted by a blade set capable of rotating for pumping fluid, and combined on a rotating shaft (201) for being driven to rotate, thereby further pumping the external fluid to pass through the heat exchanger having thermal-energy fluid pipe (100) so as to exchange heat with the heat exchanger having thermal-energy fluid pipe (100);
- - housing (208): serving as the housing for the non-contact transmission type fluid actuation device (2000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (208).

4. The heat exchanger with inner fluid to actuate the external fluid pump as claimed in claim 2, wherein the external fluid pumping blade device (202) is installed between the direct-driving type fluid actuation device (200) and the heat exchanger having thermal-energy fluid pipe (100), and it mainly consists of:
- - the direct-driving type fluid actuation device (200) is installed at one side of the heat exchanger having thermal-energy fluid pipe (100), including one of the top, the bottom, the left, the right, the front and the rear sides of the heat exchanger having thermal-energy fluid pipe (100), and the external fluid pumping blade device (202) is installed between the direct-driving type fluid actuation device (200) and the heat exchanger having thermal-energy fluid pipe (100); or
- - the direct-driving type fluid actuation device (200) is installed at any two of the top, the bottom, the right, the left, the front and the rear sides of the heat exchanger having thermal-energy fluid pipe (100) and the two external fluid pumping blade devices (202) thereof are respectively installed between the heat exchanger having thermal-energy fluid pipe (100) and the direct-driving type fluid actuation devices (200) installed at two sides of the heat exchanger having thermal-energy fluid pipe (100) and are respectively driven by the connected rotating shaft (201) of the direct-driving type fluid actuation device (200), and flowing directions of the fluids driven by the two external fluid pumping blade devices (202) are the same or different; or
- - the direct-driving type fluid actuation device (200) is installed at any two of the top, the bottom, the right, the left, the front and the rear sides of the heat exchanger having thermal-energy fluid pipe (100), and two external fluid pumping blade devices (202) thereof are respectively installed at the outer sides of the direct-driving type fluid actuation devices (200) installed at two sides of the heat exchanger having thermal-energy fluid pipe (100) and respectively driven by the connected rotating shaft (201) of the direct-driving type fluid actuation device (200), and flowing directions of the fluids driven by the two external fluid pumping blade devices (202) can be the same or different; or
- - the direct-driving type fluid actuation devices (200) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined direct-driving type fluid actuation device (200) and the other thereof is installed at the outer side of the other direct-driving type fluid actuation device (200) combined with the heat exchanger having thermal-energy fluid pipe (100), and are respectively driven by the connected rotating shaft (201) of the direct-driving type fluid actuation device (200), and flowing directions of the fluids driven by the two external fluid pumping blade devices (202) can be the same or different.

5. The heat exchanger with inner fluid to actuate the external fluid pump as claimed in claim 3, wherein the external fluid pumping blade device (202) is installed between the non-contact transmission type fluid actuation device (2000) and the heat exchanger having thermal-energy fluid pipe (100), and it mainly consists of:
- - the non-contact transmission type fluid actuation device (2000) is installed at one side of the heat exchanger having thermal-energy fluid pipe (100), including one of the top, the bottom, the left, the right, the front and the rear sides of the heat exchanger having thermal-energy fluid pipe (100), and the external fluid pumping blade device (202) is installed between the non-contact transmission type fluid actuation device (2000) and the heat exchanger having thermal-energy fluid pipe (100); or
- - the non-contact transmission type fluid actuation devices (2000) is installed at any two of the top, the bottom, the right, the left, the front and the rear sides of the heat exchanger having thermal-energy fluid pipe (100), and the two external fluid pumping blade devices (202) thereof are respectively installed between the heat exchanger having thermal-energy fluid pipe (100) and the non-contact transmission type fluid actuation devices (2000) installed at two sides of the heat exchanger having thermal-energy fluid pipe (100) and are respectively driven by the connected rotating shaft (201) of the non-contact transmission type fluid actuation devices (2000), and flowing directions of the fluids driven by the two external fluid pumping blade devices (202) can be the same or different; or
- - the non-contact transmission type fluid actuation devices (2000) are installed at any two of the top, the bottom, the right, the left, the front and the rear sides of the heat exchanger having thermal-energy fluid pipe (100), and two external fluid pumping blade devices (202) thereof are respectively installed at the outer sides of the non-contact transmission type fluid actuation devices (2000) installed at two sides of the heat exchanger having thermal-energy fluid pipe (100), and are respectively driven by the connected rotating shaft (201) of the non-contact transmission type fluid actuation devices (2000), and flowing directions of the fluids driven by the two external fluid pumping blade devices (202) can be the same or different; or
- - the non-contact transmission type fluid actuation devices (2000) is installed at any two of the top, the bottom, the right, the left, the front and the rear sides of the heat exchanger having thermal-energy fluid pipe (100), and one of the two external fluid pumping blade devices (202) thereof is installed between the heat exchanger having thermal-energy fluid pipe (100) and the combined non-contact transmission type fluid actuation device (2000) and the other thereof is installed at the outer side of the other non-contact transmission type fluid actuation device (2000) combined with the heat exchanger having thermal-energy fluid pipe (100), and are respectively driven by the connected rotating shaft (201) of the non-contact transmission type fluid actuation devices (2000), and flowing directions of the fluids driven by the two external fluid pumping blade devices (202) can be the same or different.

6. The heat exchanger with inner fluid to actuate the external fluid pump as claimed in claim 1, wherein the direct-driving type fluid actuation device (200) is installed inside the heat exchanger having thermal-energy fluid pipe (100), and the external fluid pumping blade device (202) is driven by a rotating shaft (201) installed at one side thereof, and it mainly consists of:
- - the direct-driving type fluid actuation device (200) is installed inside the heat exchanger having thermal-energy fluid pipe (100), and the external fluid pumping blade device (202) is driven by the rotating shaft (201) installed at one side of the direct-driving type fluid actuation device (200).

7. The heat exchanger with inner fluid to actuate the external fluid pump as claimed in claim 1, wherein the non-contact transmission type fluid actuation device (2000) is installed inside the heat exchanger having thermal-energy fluid pipe (100), and the external fluid pumping blade device (202) being driven by a rotating shaft (201) installed at one side thereof, and it mainly consists of:
- - the non-contact transmission type fluid actuation device (2000) is installed inside the heat exchanger having thermal-energy fluid pipe (100), and the external fluid pumping blade device (202) is driven by the rotating shaft (201) installed at the output side of non-contact transmission type fluid actuation device (210) of the non-contact transmission type fluid actuation device (2000).

8. The heat exchanger with inner fluid to actuate the external fluid pump as claimed in claim 1, wherein the direct-driving type fluid actuation device (200) is installed inside the heat exchanger having thermal-energy fluid pipe (100), and the connected external fluid pumping blade devices (202) are respectively driven by two ends of the rotating shaft (201), and it mainly consists of:
- - the direct-driving type fluid actuation device (200) is installed inside the heat exchanger having thermal-energy fluid pipe (100), and the two ends of the rotating shaft (201) of the direct-driving type fluid actuation device (200) is served for respectively connecting the external fluid pumping blade devices (202), thereby pumping the external fluids in the same or different direction.

9. The heat exchanger with inner fluid to actuate the external fluid pump as claimed in claim 1, wherein a dual-output non-contact transmission type fluid actuation device (3000) is installed inside the heat exchanger having thermal-energy fluid pipe (100), and the connected external fluid pumping blade devices (202) are respectively driven by individual rotating shafts (201) of the output sides of non-contact transmission type fluid actuation device (210) installed at two sides of the dual-output non-contact transmission type fluid actuation device (3000), and it mainly consists of:
- - the dual-output non-contact transmission type fluid actuation device (3000) is installed inside the heat exchanger having thermal-energy fluid pipe (100), and the individual rotating shafts (201) of the output sides of non-contact transmission type fluid actuation device (210) installed at two sides of the dual-output non-contact transmission type fluid actuation device (3000) respectively drive the external fluid pumping blade devices (202), thereby pumping the external fluids in the same or different direction;
- - the dual-output non-contact transmission type fluid actuation device (3000) is provided with an active side of non-contact transmission type fluid actuation device with dual functional ends (222) constituted by a fluid powering blade device (221), and active rotating parts of magnetic coupling member (212) combined and driven at the two sides, and a rotating shaft (206) and a housing (209), and is provided with two passive rotating parts of magnetic coupling member (211) inside the output side of the two non-contact transmission type fluid actuation devices (210) to perform non-contact coupling transmission with the two active rotating parts of magnetic coupling member (212) installed at two sides of the active side of non-contact transmission type fluid actuation device with dual functional ends (222); rotating shafts (201) driven by the two passive rotating parts of magnetic coupling member (211) respectively drive the external fluid pumping blade devices (202), thereby pumping the external fluids in the same or different direction;
- - the dual-output non-contact transmission type fluid actuation device (3000) is structured by one or more than one of following means which include:
1) between the active rotating part of magnetic coupling member (212) and the passive rotating part of magnetic coupling member (211), the transmission coupling is performed through the permanent magnetic pole attracting the other permanent magnetic pole;
2) between the active rotating part of magnetic coupling member (212) and the passive rotating part of magnetic coupling member (211), the transmission coupling is performed through the permanent magnetic pole attracting the coupled magnetic conductive member;
3) between the active rotating part of magnetic coupling member (212) and the passive rotating part of magnetic coupling member (211), the transmission coupling is performed through the permanent magnetic pole generating the turbine effect to the electric conductive member;
4) between the active rotating part of magnetic coupling member (212) and the passive rotating part of magnetic coupling member (211), the transmission coupling is performed through the permanent magnetic pole generating the electromagnetic effect to the squirrel-cage electromagnetic member;
5) between the active rotating part of magnetic coupling member (212) and the passive rotating part of magnetic coupling member (211), the transmission coupling is performed through the permanent magnetic pole generating the magnetic coupling effect to the reluctance structural member;
- - external fluid pumping blade devices (202): installed at two sides of the heat exchanger having thermal-energy fluid pipe (100), and respectively driven by the rotating shafts (201) of the output sides of non-contact transmission type fluid actuation device (210), thereby pumping the external fluids in the same or different direction;
- - housing (209): serving as the housing for the dual-output non-contact transmission type fluid actuation device (3000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (209).

10. The heat exchanger with inner fluid to actuate the external fluid pump as claimed in claim 1, wherein the heat exchanger having thermal-energy fluid pipe (100) is further installed with two or more than two of at least one or more than one of following fluid actuation devices, which include:
1) direct-driving type fluid actuation device (200);
2) non-contact transmission type fluid actuation device (2000); and
3) dual-output non-contact transmission type fluid actuation device (3000).

11. The heat exchanger with inner fluid to actuate the external fluid pump as claimed in claim 10, wherein two or more than two of the direct-driving type fluid actuation devices (200) are installed inside the heat exchanger having thermal-energy fluid pipe (100), and rotating shafts (201) of the direct-driving type fluid actuation devices (200) installed at the same side respectively drive the external fluid pumping blade devices (202), and it mainly consists of:
- - two or more than two of the direct-driving type fluid actuation devices (200) are installed inside the heat exchanger having thermal-energy fluid pipe (100), and rotating shafts (201) of the direct-driving type fluid actuation devices (200) installed at the same side respectively drive the external fluid pumping blade devices (202).

12. The heat exchanger with inner fluid to actuate the external fluid pump as claimed in claim 10, wherein two or more than two of the non-contact transmission type fluid actuation devices (2000) are installed inside the heat exchanger having thermal-energy fluid pipe (100), and rotating shafts (201) of the non-contact transmission type fluid actuation devices (2000) installed at the same side respectively drive the external fluid pumping blade devices (202), and it mainly consists of:
- - two or more than two of the non-contact transmission type fluid actuation devices (2000) are installed inside the heat exchanger having thermal-energy fluid pipe (100); and rotating shafts (201) of the output sides of non-contact transmission type fluid actuation devices (210) installed at the same side of the non-contact transmission type fluid actuation devices (2000) respectively drive the external fluid pumping blade devices (202).

13. The heat exchanger with inner fluid to actuate the external fluid pump as claimed in claim 10, wherein two or more than two of the direct-driving type fluid actuation devices (200) are installed inside the heat exchanger having thermal-energy fluid pipe (100), and two ends of each rotating shafts (201) of the direct-driving type fluid actuation devices (200) respectively drive the connected external fluid pumping blade devices (202), and it mainly consists of:
- - two or more than two of the direct-driving type fluid actuation devices (200) are installed inside the heat exchanger having thermal-energy fluid pipe (100), and two ends of each rotating shafts (201) of the direct-driving type fluid actuation devices (200) respectively connect with the external fluid pumping blade devices (202), thereby pumping the external fluids in the same or different direction.

14. The heat exchanger with inner fluid to actuate the external fluid pump as claimed in claim 10, wherein two or more than two of the dual-output non-contact transmission type fluid actuation devices (3000) are installed inside the heat exchanger having thermal-energy fluid pipe (100), and individual rotating shafts (201) of the output sides of non-contact transmission type fluid actuation device (210) installed at two sides of the dual-output non-contact transmission type fluid actuation devices (3000) respectively drive the connected external fluid pumping blade devices (202), and it mainly consists of:
- - two or more than two of the dual-output non-contact transmission type fluid actuation devices (3000) are installed inside the heat exchanger having thermal-energy fluid pipe (100), and individual rotating shafts (201) of the output sides of non-contact transmission type fluid actuation device (210) installed at two sides of the dual-output non-contact transmission type fluid actuation devices (3000) respectively drive the external fluid pumping blade devices (202), thereby pumping the external fluids in the same or different direction;
- - the dual-output non-contact transmission type fluid actuation device (3000) is installed with a fluid powering blade device (221), active rotating parts of magnetic coupling member (212) combined at two sides for driving, a rotating shaft (206) and a housing (209) to together constituted an active side of non-contact transmission type fluid actuation device with dual functional ends (222), and two sides of the active side of non-contact transmission type fluid actuation device with dual functional ends (222) are respectively installed with the output sides of non-contact transmission type fluid actuation device (210), and passive rotating parts of magnetic coupling member (211) are installed inside the output sides of non-contact transmission type fluid actuation device (210) for serving to perform non-contact coupling transmission with the two active rotating parts of magnetic coupling member (212) installed at two sides of the active side of non-contact transmission type fluid actuation device with dual functional ends (222), and rotating shafts (201) driven by the two passive rotating parts of magnetic coupling member (211) respectively drive the external fluid pumping blade devices (202), thereby pumping the external fluids in the same or different direction;
- - the dual-output non-contact transmission type fluid actuation device (3000) is structured by one or more than one of following means which include:
1) between the active rotating part of magnetic coupling member (212) and the passive rotating part of magnetic coupling member (211), the transmission coupling is performed through the permanent magnetic pole attracting the other permanent magnetic pole;
2) between the active rotating part of magnetic coupling member (212) and the passive rotating part of magnetic coupling member (211), the transmission coupling is performed through the permanent magnetic pole attracting the coupled magnetic conductive member;
3) between the active rotating part of magnetic coupling member (212) and the passive rotating part of magnetic coupling member (211), the transmission coupling is performed through the permanent magnetic pole generating the turbine effect to the electric conductive member;
4) between the active rotating part of magnetic coupling member (212) and the passive rotating part of magnetic coupling member (211), the transmission coupling is performed through the permanent magnetic pole generating the electromagnetic effect to the squirrel-cage electromagnetic member;
5) between the active rotating part of magnetic coupling member (212) and the passive rotating part of magnetic coupling member (211), the transmission coupling is performed through the permanent magnetic pole generating the magnetic coupling effect to the reluctance structural member;
- - external fluid pumping blade devices (202): installed at two sides of the heat exchanger having thermal-energy fluid pipe (100), and are respectively driven by the rotating shafts (201) of the output sides of non-contact transmission type fluid actuation device (210), thereby pumping the external fluids in the same or different direction;
- - Housing (209): serving as the housing for the dual-output non-contact transmission type fluid actuation device (3000), and constituted by non-magnetic conductive and non-electric conductive materials, or constituted by a material with both of one of the properties of electric conductivity and magnetic conductivity, wherein the electric conductivity and magnetic conductivity do not affect the transmission of the required rotational kinetic energy between the active rotating part of magnetic coupling member (212) and the passive rotating part of magnetic coupling member (211) installed at two sides of the housing (209).
